# EUROPEAN PATENT APPLICATION

(11) **EP 1 980 883 A1**
(43) Date of publication of application: **15.10.2008**
(21) Application number: 07707982.0
(22) Date of filing: 30.01.2007
(51) Int. Cl.: G02B 6/12, G02B 6/122, G02B 27/28, H01S 5/026

(54) **INTEGRATED LIGHT ISOLATOR**

(30) Priority: 31.01.2006 JP 2006021689
(71) Applicant: TOKYO INSTITUTE OF TECHNOLOGY, Tokyo 152-8550 (JP)
(72) Inventor: MIZUMOTO, Tetsuya, Meguro-Ku, Tokyo 152-8550 (JP); SAKURAI, Kazumasa, Meguro-Ku, Tokyo 152-8550 (JP)
(74) Representative: Grünecker, Kinkeldey, Stockmair & Schwanhäusser Anwaltssozietät
(86) International application number: PCT/JP2007/051851
(87) International publication number: WO 2007/088991

(57) **Abstract**

There is provided an integrated optical isolator has a structure obtained by integrating a semiconductor laser and an optical isolator, simple manufacturing steps, efficiently absorbs a backward propagation light of the optical isolator, and prevents a stray light from being generated. In an integrated optical isolator in which a semiconductor waveguide layer is layered on a compound semiconductor substrate, a semiconductor laser is formed on a one-side part of the semiconductor waveguide layer, and an optical isolator is formed on an other-side part, a laser current injection electrode is arranged on an upper portion of an active layer of a certain semiconductor waveguide layer in the semiconductor laser, terminal absorbing layers are arranged at the backward propagation light output waveguide output end of the optical isolator on both sides of the semiconductor laser.

## Description

### Technical Field

The present invention relates to a structure of an optical isolator (or optical circulator) serving as an optical non-reciprocal element, and particularly to an integrated optical isolator which a backward propagation light of an optical isolator is efficiently absorbed by a structure in which a semiconductor laser and an optical isolator are integrated in a body with matching so as to prevent a stray light from being generated.

### Background Art

An optical isolator is an element which transmits a light in only one direction and blocks a light to be propagated in a direction opposing the above direction. For example, the optical isolator is arranged at a laser-emitting end of a semiconductor laser, so that light emitted from the laser is transmitted through the optical isolator and can be used as a light source for optical fiber communication or the like. Reversely, the light to be incident on the semiconductor laser through the optical isolator is blocked by the optical isolator and cannot be incident on the semiconductor laser. When the optical isolator is not arranged at a laser-emitting end of the semiconductor laser, a reflected return light is incident on the semiconductor laser to deteriorate oscillation characteristics of the semiconductor laser. More specifically, the optical isolator has operations which shield a light to be incident on the semiconductor laser and keep a stable oscillation (light emission) without deteriorating the characteristics of the semiconductor laser.

When an external light is incident on the semiconductor laser, a fluctuation (generation of an intensity noise) in output intensity of the semiconductor laser and a change (generation of a phase noise) in oscillation wavelength cause a problem in the optoelectronics field. In order to prevent the problem, an optical isolator which blocks a backward propagation light must be arranged at an output end of the semiconductor laser so as to take a countermeasure against the disadvantage in light emission of the semiconductor laser. In particular, when a semiconductor laser is used as a light source for high-speed optical fiber communication, a stable oscillation of a light source (semiconductor laser) is required as an absolute condition. For this reason, the optical isolator is necessarily used.

### <Document List>

(Patent Document 1)
   Japanese Patent No. 3407046 B2
(Patent Document 2)
   Japanese Patent Application Laid-open No. 2001-350039 A

### Disclosure of the Invention

An optical isolator is an element which prevents a light from being incident on a semiconductor laser and which is necessary and indispensable for a stable oscillation of the semiconductor laser. For the purpose of use, it is desired that the optical isolator and the semiconductor laser are integrated in a body. However, in a conventional art, a semiconductor laser and an optical isolator are not integrally mounted.

When only the optical isolator is considered, a reflected return light is radiated in a direction misaligned from an optical axis by a polarizer arranged in the optical isolator. A backward propagation light blocked by the optical isolator becomes a stray light, and the stray light is incident on the semiconductor laser through an unexpected path or is propagated to an external optical circuit as an unnecessary output light so as to cause a problem. In particular, when an interference-type optical isolator as described in Japanese Patent No. 3407046 B2 (Patent Document 1) is used, a mechanism which absorbs the backward propagation light therein is not arranged, and the output light is radiated from a backward propagation light output waveguide to the outside. In a case that the optical isolator and the semiconductor laser are integrated in a body, the radiated light becomes a stray light and then the stray light is undesirably incident on the semiconductor laser. In this connection, it is important that a light radiated outside of the optical isolator should be appropriately processed.

By the way, a structure using the following known technique can absorb a backward propagation light and prevent to generate a stray light. That is, since the above optical isolator operates in a TM-mode, a light radiated outward by the optical isolator is a TM-mode light. It is known that the TM-mode light is efficiently absorbed by a metal clad layer (for example, Al or Au) arranged on an upper clad of an optical waveguide. According to this method, a light radiated outward from the optical isolator can be absorbed.

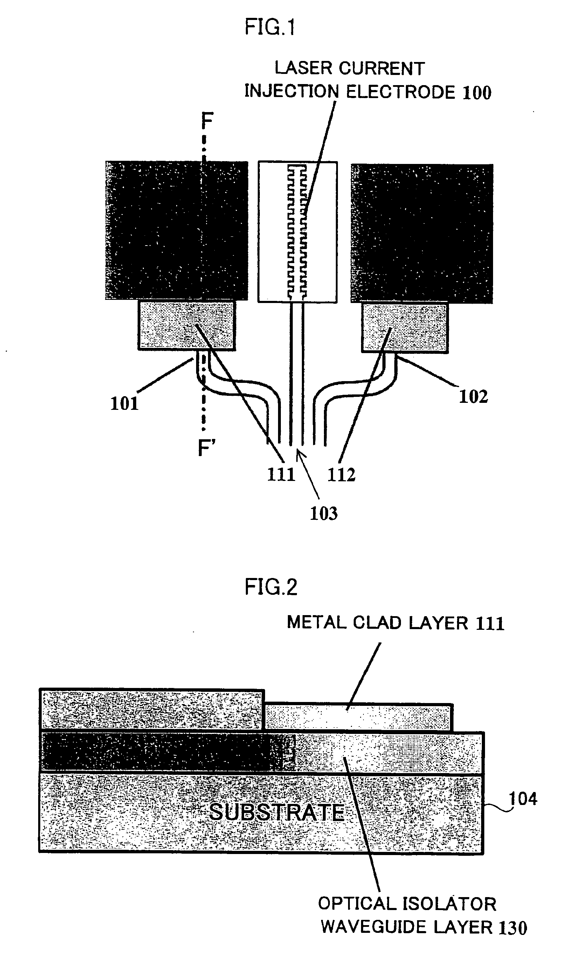

More specifically, according to a terminal structure of a conventional optical isolator shown in FIGs. 1 and 2, a backward propagation light guided on backward propagation light output waveguides 101 and 102 toward a semiconductor laser are absorbed by the operations of metal clad layers 111 and 112 arranged on the upper portions of the backward propagation light output waveguides 111 and 112 , and it is possible to prevent a generation of a stray light. FIG. 1 shows a planar structure of a light-shielding section, and FIG. 2 is a sectional view of an F - F' line in FIG. 1. A laser beam from the semiconductor laser is inputted from an input end 103 of the optical isolator to the optical isolator by applying a predetermined voltage to the laser current injection electrode 100. The laser beam is propagated through the optical isolator in a forward direction and supplied to an external optical circuit.

As described above, when the metal clad layers 111 and 112 as an upper clad of an optical isolator waveguide layer 130 are directly formed on the optical isolator waveguide layer 130 or are formed through an appropriate buffer layer, a light propagated through the optical isolator waveguide layer 130 can be effectively absorbed by the metal clad layers 111 and 112.

However, in the optical isolatorhaving the above structure, it is necessary to take measures to prevent that a metal clad layer is formed on a part which do not require the metal clad layers 111 and 112 or on a part (for example, on the optical isolator waveguide) on which the metal clad layers 111 and 112 should not be inconveniently formed. That is, the metal clad layer must be partially removed, or a measure to prevent the metal clad layer from influence of the light waveguide must be taken.

Therefore, the conventional integrated optical isolator with the semiconductor laser requires at least the step of forming a metal clad layer and the step of performing a patterning process to prevent the metal clad layer from partially influencing an operation of an optical isolator. The manufacturing steps are complicated and uneconomical.

The present invention has been made in consideration of the above circumstances, and the object of the present invention is achieved by providing an integrated optical isolator which has a structure obtained by integrating a semiconductor laser and an optical isolator, simple manufacturing steps, efficiently absorbs a backward propagation light of the optical isolator, and prevents a stray light from being generated. As in the present invention, when a device obtained by integrating the optical isolator and the semiconductor laser is formed, a backward propagation light removed from an optical path by the optical isolator can be reliably prevented from being unintentionally incident on the semiconductor laser again by reflection on a device inside or a package wall surface.

The present invention relates to an integrated optical isolator in which a semiconductor waveguide layer is grown on a compound semiconductor substrate, a semiconductor laser is formed on a one-side part of the semiconductor waveguide layer, and an optical isolator is formed on an other-side part. The object of the present invention is achieved by an integrated optical isolator in which a laser current injection electrode is arranged on an upper portion of an active layer of a semiconductor waveguide layer in the semiconductor laser, terminal absorbing layers are arranged at the backward propagation light output waveguide output end of the optical isolator on both sides of the semiconductor laser, or the terminal absorbing layer causes the semiconductor waveguide layer to act as a light-absorbing layer, and a semiconductor clad layer is mounted on an upper portion of the terminal absorbing layer.

The present invention relates to an integrated optical isolator in which a semiconductor waveguide layer is grown on a compound semiconductor substrate, a semiconductor laser is formed on a one-side part of the semiconductor waveguide layer, and an optical isolator is formed on an other-side part. The object of the present invention is achieved by an integrated optical isolator in which a semiconductor clad layer and an insulating layer are laminated on the semiconductor waveguide layer and the semiconductor laser at a background propagation light output waveguide output end of the optical isolator, a laser current injection electrode is deposited on the semiconductor clad layer and the insulating layer, the semiconductor waveguide layer at the backward propagation light output waveguide output end of the optical isolator serves as a terminal absorbing layer, and the insulating layer is laminated on a part serving as an internal terminal absorbing layer of the semiconductor waveguide layer, the laser current injection electrode is deposited on only a semiconductor laser portion, the laser current injection electrode is deposited on the semiconductor laser portion and a part or whole of the terminal absorbing layer, the insulating layer is made of SiO₂, or the insulating layer is made of Al₂O₃.

The present invention relates to an integrated optical isolator in which a semiconductor waveguide layer is laminated on a compound semiconductor substrate, a semiconductor laser is formed on a one-side part of the semiconductor waveguide layer, and an optical isolator is formed on an other-side part. The object of the present invention is achieved by an integrated optical isolator in which a semiconductor clad layer is formed at a backward propagation light output waveguide output end of the optical isolator, a laser current injection electrode is formed on a light-emitting waveguide, and a semiconductor waveguide layer under the semiconductor clad layer at the backward propagation light output waveguide output end of the optical isolator serves as a terminal absorbing layer, or an isolation portion is formed between a part of the laser current injection electrode and the terminal absorbing layer arranged at the backward propagation light output waveguide output end of the optical isolator.

The present invention relates to an integrated optical isolator in which a semiconductor waveguide layer is grown on a compound semiconductor substrate, a semiconductor laser is formed on a one-side part of the semiconductor waveguide layer, and an optical isolator is formed on an other-side part. The object of the present invention is achieved by an integrated optical isolator in which only a region for the optical isolator is removed after layers of the semiconductor laser are formed, the part of the optical isolator is formed by a two-step growth which performs re-growth as another crystal growth process, or the semiconductor waveguide layer of the optical isolator is formed simultaneously with the crystal growth process which forms the layers of the semiconductor laser.

### Brief Description of the Drawings

In the accompanying drawings:
FIG. 1 is a diagram showing a structure example of a terminal of a conventional general optical isolator;
FIG. 2 is a sectional view of an F - F' line in FIG. 1;
FIG. 3 is a perspective structural diagram showing an embodiment of an integrated optical isolator according to the present invention;
FIG. 4 is a plan view of a C - C' line in FIG. 3;
FIG. 5 is a sectional view of a D - D' line in FIG. 4;
FIG. 6 is a plan view showing another embodiment of the present invention;
FIG. 7 is a sectional view of an E - E' line in FIG. 6;
FIG. 8 is a plan view in a case that a laser current injection electrode is arranged in the form of a character-I;
FIG. 9 is a plan view in a case that a laser current injection electrode is arranged in the form of a character-T;
FIG. 10 is a sectional view showing still another embodiment of the present invention;
FIGs. 11 (a) to 11 (h) are diagrams showing a growth process by a two-step growth of an integrated optical isolator; and
FIGs. 12 (a) to 12 (d) are diagrams showing a growth process by a selective growth of an integrated optical isolator.

### Best Mode for Carrying Out the Invention

An active layer (narrow-band gap layer) serving as a light-emitting layer of a semiconductor laser emits a light with a gain when a current having a predetermined threshold or more is injected into the active layer. However, when the injection current does not reach the threshold, the active layer absorbs the light. When a device obtained by integrating an optical isolator and a semiconductor laser in a body is to be formed, the heights of waveguide layers (waveguides) of both the elements must be equal to each other. Therefore, a region which is formed simultaneously with the active layer of the semiconductor laser but into which no current is injected is caused to act as a light-absorbing layer,and a backward propagation light radiated as an unnecessary light from the waveguide layer of the optical isolator can be absorbed by a terminal absorbing layer on the semiconductor laser side.

The present invention is based on the above circumstances, and proposes an integrated optical isolator: Narrow-band gap layers simultaneously formed by a crystal growth are used at both sides of a light-emitting layer of an integrated semiconductor laser as terminal absorbing layers, so that the integrated optical isolator which has a structure matching with an integrated semiconductor laser with an optical isolator and which can efficiently absorb a backward propagation light to prevent a generation of a stray light.

Embodiments of the present invention will be described below with reference to the accompanying drawings.

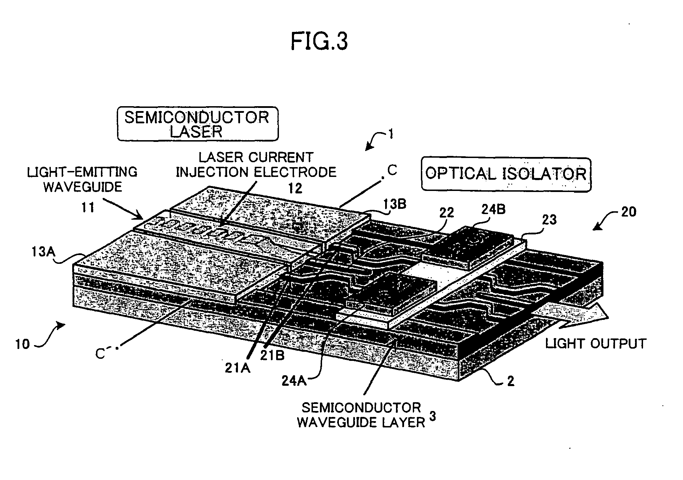

FIG. 3 shows a perspective structure of an integrated optical isolator 1 according to the present invention, and a semiconductor laser 10 which emits a laser and an optical isolator 20 serving an optical non-reciprocal element are connected to each other and integrally formed on a compound semiconductor substrate 2 and a semiconductor waveguide layer 3. A light-emitting waveguide 11 for a light-emitting output is formed on the semiconductor waveguide layer 3 of the semiconductor laser 10, and a laser current injection electrode 12 is provided thereon. Semiconductor clad layers 13A and 13B to form light-absorbing regions are arranged on both sides of the laser current injection electrode 12.

Backward propagation light output waveguides 21A and 21B are formed at positions corresponding to the semiconductor clad layers 13A and 13B are formed on the semiconductor waveguide layer 3 of the optical isolator 20, and an input waveguide 22 is formed in association with the light-emitting waveguide 11. A magneto-optical material 23 is further bonded on the semiconductor waveguide layer 3 such that the magneto-optical material 23 intersect a light guide direction, and permanent magnets 24A and 24B serving a magnetic field section are arranged on the magneto-optical material 23.

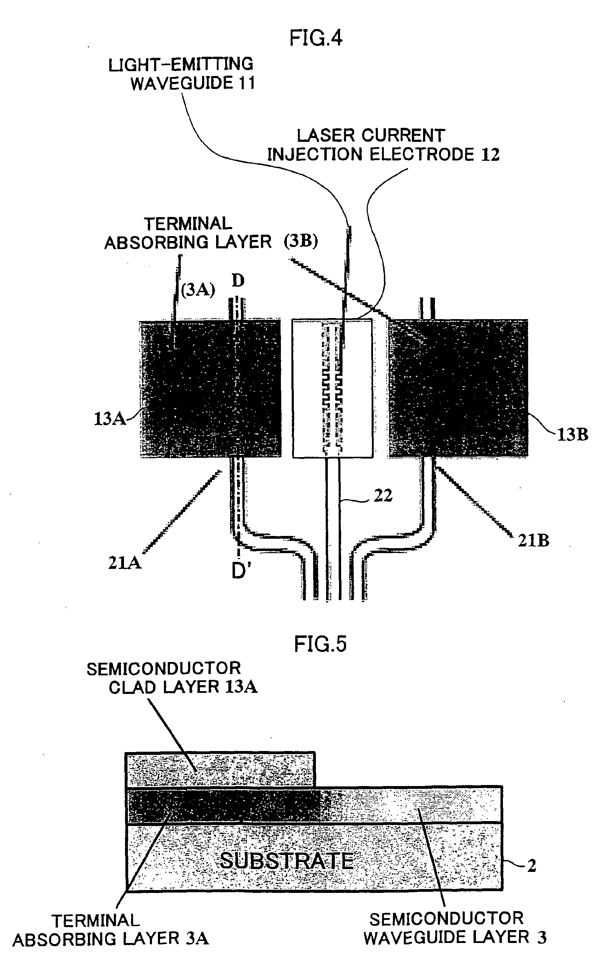

FIG. 4 shows a planar structure along a C - C' line in FIG. 3, and FIG. 5 shows a sectional structure along a D - D' line in FIG. 4. Parts of the semiconductor waveguide layer 3 under the semiconductor clad layers 13A and 13B of the optical isolator 20 serve as terminal absorbing layers 3A and 3B acting as light-absorbing layers, and the other part of the semiconductor waveguide layer 3 acts as an optical isolator waveguide (optical waveguide layer). A structure of a connection portion between the optical isolator 20 and the semiconductor laser 10 is a structure as shown in FIGs. 4 and 5, and respective layers (including the active layer (semiconductor waveguide layer 3)) required to configure the semiconductor laser 10 are formed by continuous crystal growth processes with matching.

On the other hand, the waveguide layer (semiconductor waveguide layer 3) of the optical isolator 20 has a composition different from that of the active layer of the semiconductor laser 10, and the waveguide layer must be a low-absorbing semiconductor layer having less absorbance at a lasing wavelength of the semiconductor laser 10. The waveguide layer (semiconductor waveguide layer 3) of the optical isolator 20 can be formed by a two-step growth in which only a region for the optical isolator 20 is removed after the layers of the semiconductor laser 10 are formed to perform a re-growth as another crystal growth process. The waveguide layer can also be formed by using a selective growth method simultaneously with the crystal growth process for forming the layers of the semiconductor laser 10. Even though any one of the methods, in the forward direction, in order to cause a light output from the semiconductor laser 10 to be efficiently incident on the optical isolator 20, the widths (height direction) of the active layer (semiconductor waveguide layer 3) of the semiconductor laser 10 and the waveguide layer (semiconductor waveguide layer 3) for the optical isolator 20 must be accurately equal to each other. Since the widths of the active layer of the semiconductor laser 10 and the waveguide layer for the optical isolator 20 are equal to each other in the height direction, the structure efficiently waveguides a backward propagation light to the terminal absorbing layers 3A and 3B and effectively absorbs the backward propagation light.

In manufacturing of the integrated optical isolator 1 according to the present invention having the above structure, the active layer (semiconductor waveguide layer 3) for forming the semiconductor laser 10 and the optical waveguide layer (semiconductor waveguide layer 3) of the optical isolator 20 are formed at the same position in the height direction. In the active layer (semiconductor waveguide layer 3) for forming the semiconductor laser 10, a current from the laser current injection electrode 12 is selectively injected into only the light-emitting waveguide 11, i.e., a part which is desired to emit a light, of the semiconductor laser 10 so as to act as a semiconductor laser. No current is injected into the other active layer (semiconductor waveguide layer 3) to cause the optical waveguide layer (semiconductor waveguide layer 3) as the terminal absorbing layers 3A and 3B. In the optical isolator 20, the backward propagation light returning to the semiconductor laser 10 is guided to the backward propagation light output waveguides 21A and 21B, and backward propagation lights radiated from the backward propagation light output waveguides 21A and 21B are guided to the terminal absorbing layers 3A and 3B arranged at the backward propagation light output waveguide output end of the optical isolator 20. In this manner, the terminal absorbing layers 3A and 3B absorb the backward propagation light from the optical isolator 20.

In the integrated optical isolator 1 having the structure shown in FIGs. 3 to 5, a light to be incident from the optical isolator 20 on the device (the backward propagation light output waveguides 21A and 21B) becomes a backward propagation light to be removed in the optical isolator 20 or the semiconductor laser 10. The backward propagation light is guided to the backward propagation light output waveguides 21A and 21B by an operation of the optical isolator 20 and is absorbed by the terminal absorbing layers 3A and 3B arranged at the backward propagation light output waveguide output end of the optical isolator 20, and the absorption prevents the backward propagation light from being incident on the light-emitting waveguide 11 of the semiconductor laser 10 as a stray light. More specifically, when the terminal absorbing layers 3A and 3B are not formed, a light radiated from the optical isolator 20 may be guided to the backward propagation light output waveguides 21A and 21B and incident on the semiconductor laser 10 as a stray light. However, in the integrated optical isolator 1 in the present invention, since the light radiated from the backward propagation light output waveguides 21A and 21B is absorbed (removed) by the terminal absorbing layers 3A and 3B located under the semiconductor clad layers 13A and 13B, a stray light can be prevented from being generated.

As described above, according to the present invention, the backward propagation light output waveguides 21A and 21B are connected to the terminal absorbing layers (active layers into which no current is injected) 3A and 3B formed simultaneously with the semiconductor laser active layer (semiconductor waveguide layer 3) to cause the terminal absorbing layers 3A and 3B to absorb the backward propagation light. For this reason, a high-performance optical isolator which prevents a stray light from being generated and which is excellent in backward propagation blocking characteristic can be provided.

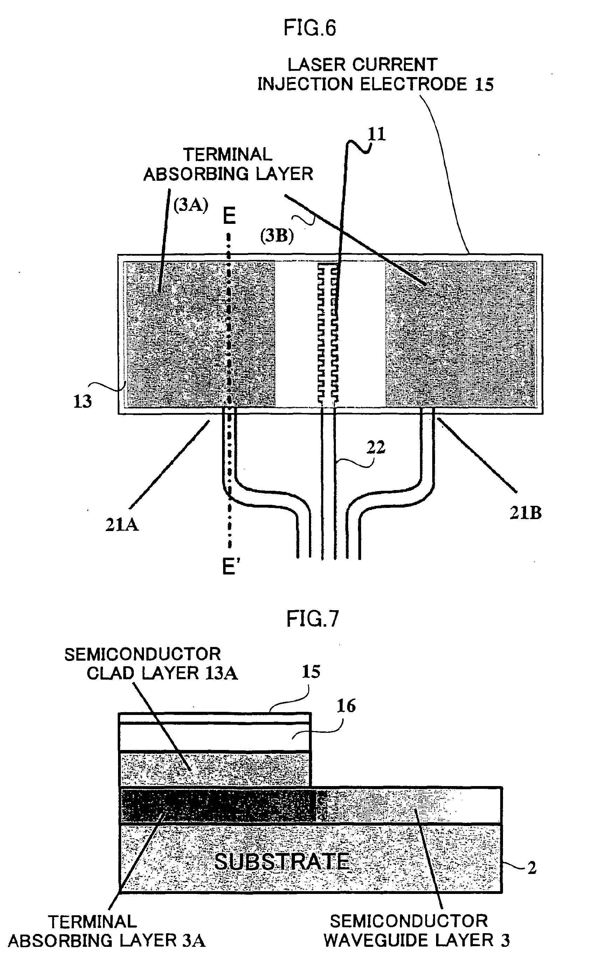

The same action as described in the above embodiment can also be realized by an integrated optical isolator having a structure shown in FIGs. 6 and 7. In this embodiment, a semiconductor clad layer 13 is formed in regions (terminal absorbing layers 3A and 3B) which are desired to be caused to absorb a backward propagation light on the semiconductor waveguide layer 3 and in a laser-emitting region. On the semiconductor clad layer 13, in order to prevent a current from being injected into the regions of the terminal absorbing layers 3A and 3B, an insulating layer (for example, SiO₂, Al₂O₃ or the like) 16 is laminated on portions corresponding to the regions. Furthermore, the entire areas of the upper portions of the laser-emitting region and the insulating layer 16 are covered with a laser current injection electrode 15. Since the isolated insulating layers 16 are arranged on both sides of the lower side of the laser current injection electrode 15, a structure in which current is not injected into the regions of the insulating layers 16 is obtained. However, the insulating layer 16 is not arranged in the laser-emitting region to inject a current from the laser current injection electrode 15 into the laser-emitting region. According to the above embodiment, a current is not injected into the region serving as a light-absorbing layer due to the insulating layer 16, so that the terminal absorbing layers 3A and 3B can be formed.

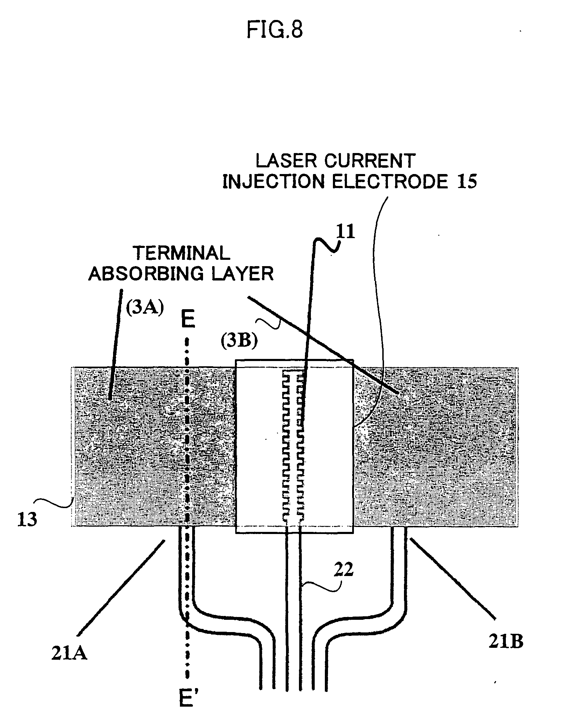

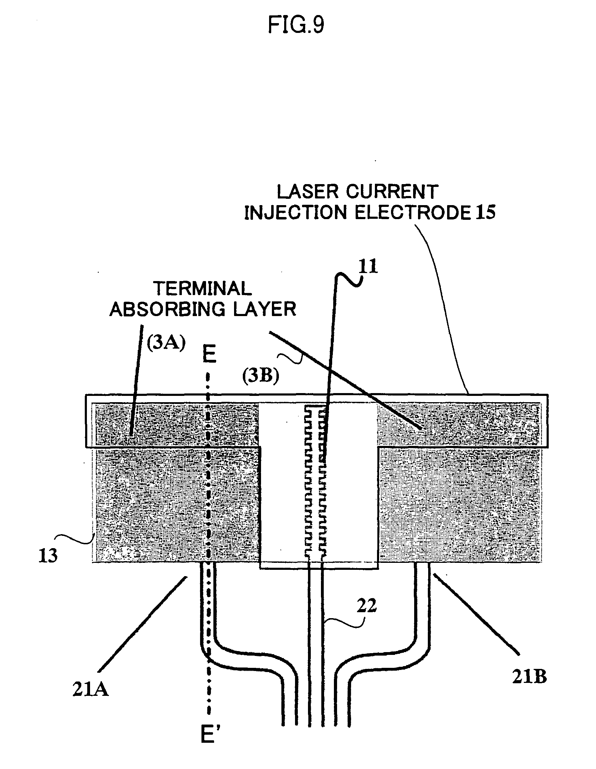

In the embodiment in FIG. 6, the laser current injection electrodes are arranged on the entire surface of regions (terminal absorbing layers 3A and 3B) which are desired to be caused to absorb a backward propagation light and of the laser-emitting region. However, if there is provided a structure that a current is not injected into the terminal absorbing layers 3A and 3B, the electrodes need not be arranged on the terminal absorbing layers 3A and 3B. The insulating layers exist on the terminal absorbing layers 3A and 3B and a structure in which no current is injected into the upper portions of the terminal absorbing layers 3A and 3B is provided, and therefore the laser current injection electrode may be arranged in only the laser-emitting region as shown in FIG. 8 (I-type), or the laser current injection electrode may be arranged in the form of a character-T as shown in FIG. 9. The laser current injection electrode must be arranged in the laser-emitting region. However, a planar shape of the laser current injection electrode is arbitrarily determined in the other region in which the insulating layer is arranged.

Even in the embodiment in FIGs. 3 to 5 and the embodiment in FIGs. 6 to 9, an active layer (semiconductor waveguide layer 3) of the semiconductor laser 10 has a gain obtained by a current injection from the laser current injection electrodes 12 and 15 on a part of the light-emitting waveguide 11 of the semiconductor laser 10 and acts as a light-emitting layer. However, no current is injected into the other region, the region acts as a terminal absorbing layer. More specifically, in the optical isolator 20, the backward propagation light reaches the terminal absorbing layers 3A and 3B in FIG. 4, FIG. 6, FIG. 8 and FIG. 9 by the action of the optical isolator 20. Then, the backward propagation light is incident on the terminal absorbing layers 3A and 3B arranged at the same height as that of the backward propagation light output waveguides 21A and 21B of the optical isolator 20. The backward propagation light is propagated in an appropriate distance in the terminal absorbing layers 3A and 3B and then is attenuated to a light having a sufficiently small optical power. Regarding degrees of attenuation in the terminal absorbing layers 3A and 3B, an attenuation of -21.7 [dB] is given in a propagation distance of 100 [µm] when the absorption coefficients of the terminal absorbing layers 3A and 3B are 500 [cm-¹], and an attenuation of - 43.4 [dB] is given in a propagation distance of 100 [µm] when the absorption coefficients of the terminal absorbing layers 3A and 3B are 1000 [cm⁻¹].

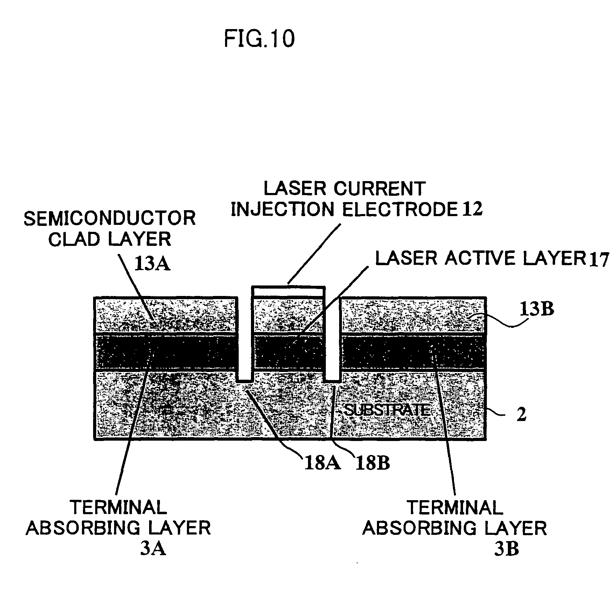

FIG. 10 shows still another embodiment of the present invention, and a structure in which a laser active layer 17 obtained by a laser current injection electrode 12 is isolated from terminal absorbing layers 3A and 3B by isolation portions 18A and 18B. The isolation portions 18A and 18B reach from upper surfaces of semiconductor clad layers 13A and 13B to an upper surface position of a compound semiconductor substrate 2. A laser current injection electrode 12 is arranged between the isolation portions 18A and 18B to form a laser active layer 17 and to prevent an injection current from flowing into the terminal absorbing layers 3A and 3B, and a weak leakage light from the terminal absorbing layers 3A and 3B to the semiconductor laser 10 can be further attenuated.

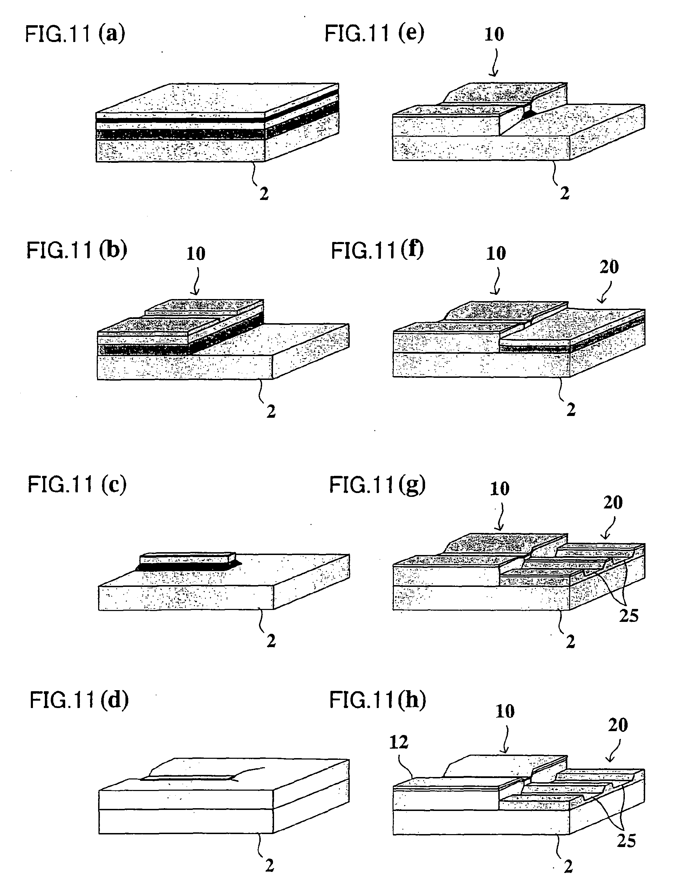

As a method of manufacturing an integrated optical isolator according to the present invention, a method of performing a two-step growth as a crystal growth method and a method of performing a selective growth may be used. Growth processes in the two-step growth are schematically shown in FIGs. 11(a) to 11(h). First, layers of a semiconductor laser 10 are formed, and the region of an optical isolator 20 is removed. Thereafter, an optical isolator portion is re-grown by another crystal growth process. More specifically, first, only an active element is formed, next, the other portion is removed, and thereafter a layer for a passive portion is newly formed.

Concretely, as shown in FIG. 11(a), the layers of the semiconductor laser 10 are formed. At this time, with respect to the compound semiconductor substrate 2, a portion for forming the optical isolator 20 is also formed. Next, as shown in FIG. 11(b), a portion to be the optical isolator 20 is removed by etching except for the layer of the compound semiconductor substrate 2. In an etching in FIG. 11(c), a growth in FIG. 11(d) and an etching process in FIG. 11(e), a laser-emitting region of the semiconductor laser 10 and a region to be a terminal absorbing layer are patterned. Thereafter, as shown in FIG. 11(f), the layers above the compound semiconductor substrate 2 of the optical isolator 20 are grown, and parts of the optical isolator 20 such as the waveguides 25 of an input waveguide 22 and a backward propagation light output waveguide 21 are patterned. Finally, as shown in FIG. 11(h), the laser current injection electrode 12 is arranged.

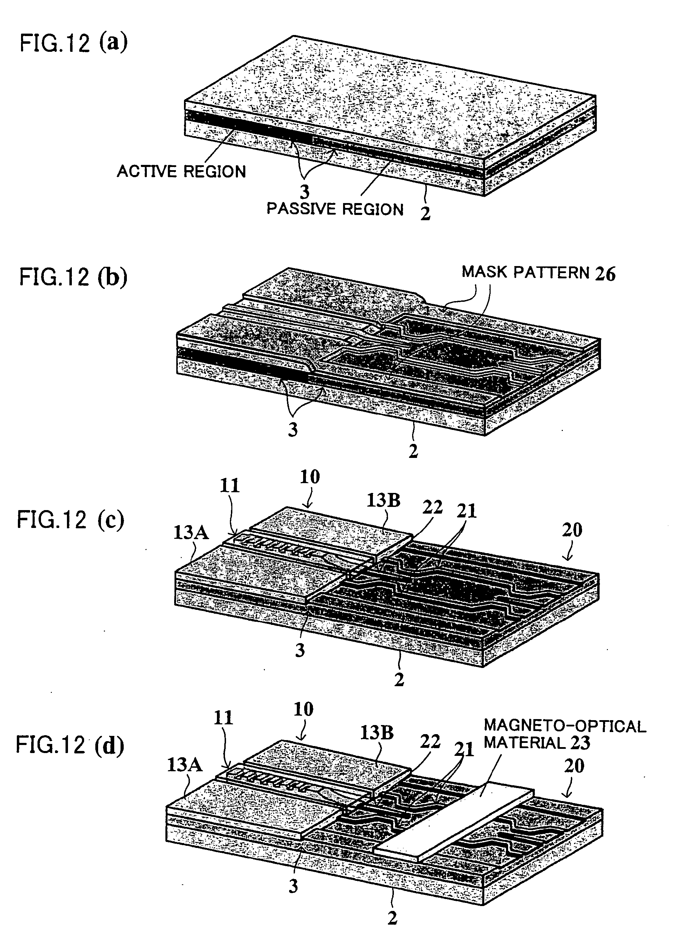

Growth processes of the selective growth are shown in FIGs. 12(a) to 12(d). In the selective growth, a mask is formed on the substrate, and a layer is formed on the mask. At this time, by using the fact that crystal growth speeds depend on mask shapes, an active region and a passive region, i.e., the layers of the semiconductor laser 10 and the optical isolator 20 are simultaneously formed. Thereafter, by patterning, the elements are formed. First, as shown in FIG. 12(a), a wafer including layers corresponding to the compound semiconductor substrate 2 and the semiconductor waveguide layer 3 is formed. Next, as shown in FIG. 12(b), a mask pattern 26 is formed by lithography on the wafer. From the mask pattern 26, as shown in FIG. 12(c), growths for the elements of the semiconductor laser 10 including the light-emitting waveguide 11, the semiconductor clad layers 13A and 13B and the like, and of the optical isolator 20 including the input waveguide 22, the backward propagation light output waveguide 21 and the like are performed. Finally, as shown in FIG. 12(d), the magneto-optical material 23 is bonded.

According to the integrated optical isolator of the present invention, a structure obtained by integrating the semiconductor laser and the optical isolator with each other is employed, and an absorbing layer is formed simultaneously with the active layer (semiconductor waveguide layer) of the semiconductor laser. The moment a waveguide pattern for the optical isolator is formed, a waveguide which guides an unnecessary backward propagation light to the absorbing layer may be formed. The number of manufacturing steps does not increase due to removal of a stray light, and the manufacturing steps are simple. A backward propagation light of the optical isolator is efficiently absorbed, and the stray light can be advantageously prevented from being generated.

As described above, the integrated optical isolator according to the present invention has the following two considerable features.
(1) A current is injected into an active layer (semiconductor waveguide layer) to be caused to function as a light-emitting layer of a semiconductor laser. In a region into which a current is not injected, the active layer can be caused to act as a light-absorbing layer. Therefore, a backward propagation light is absorbed by a terminal absorbing layer, unnecessary manufacturing steps need not added to prevent the background propagation light from being radiated to the outside of the waveguide as a stray light, and the integrated optical isolator can be easily manufactured.
(2) Since the terminal absorbing layer is formed at the same height as that of the light-emitting layer of the semiconductor laser and the waveguide layer of the optical isolator, the backward propagation light of the optical isolator can be efficiently absorbed by the terminal absorbing layer.

## Claims

1. An integrated optical isolator, wherein a semiconductor waveguide layer is grown on a compound semiconductor substrate, a semiconductor laser is formed on a one-side part of the semiconductor waveguide layer, and an optical isolator is formed on an other-side part,
wherein a laser current injection electrode is arranged on an upper portion of an active layer of a certain semiconductor waveguide layer in the semiconductor laser, and terminal absorbing layers are arranged at a backward propagation light output waveguide output end of the optical isolator on both sides of the semiconductor laser.

2. An integrated optical isolator according to claim 1, wherein
the terminal absorbing layer is obtained by causing the semiconductor waveguide layer to act as a light-absorbing layer, and a semiconductor clad layer is mounted on an upper portion of the terminal absorbing layer.

3. An integrated optical isolator, wherein a semiconductor waveguide layer is grown on a compound semiconductor substrate, a semiconductor laser is formed on a one-side part of the semiconductor waveguide layer, and an optical isolator is formed on an other-side part,
wherein a semiconductor clad layer and an insulating layer are laminated on the semiconductor waveguide layer and the semiconductor laser at a background propagation light output waveguide output end of the optical isolator, a laser current injection electrode is laminated on the semiconductor clad layer and the insulating layer, the semiconductor waveguide layer at the backward propagation light output waveguide output end of the optical isolator serves as a terminal absorbing layer, and the insulating layer is laminated on a part serving as an internal terminal absorbing layer of the semiconductor waveguide layer.

4. An integrated optical isolator according to claim 3, wherein the laser current injection electrode is laminated on only a semiconductor laser portion.

5. An integrated optical isolator according to claim 3, wherein the laser current injection electrode is laminated on the semiconductor laser portion and a part orwhole of the terminal absorbing layer.

6. An integrated optical isolator according to any one of claims 3 to 5, wherein the insulating layer is made of SiO₂.

7. An integrated optical isolator according to any one of claims 3 to 5, wherein the insulating layer is made of Al₂O₃.

8. An integrated optical isolator, wherein a semiconductor waveguide layer is laminated on a compound semiconductor substrate, a semiconductor laser is formed on a one-side part of the semiconductor waveguide layer, and an optical isolator is formed on an other-side part,
wherein a semiconductor clad layer is formed at a backward propagation output waveguide output end of the optical isolator, a laser current injection electrode is formed on a light-emitting waveguide, and a semiconductor waveguide layer under the semiconductor clad layer at the backward propagation light output waveguide output end of the optical isolator serves as a terminal absorbing layer.

9. An integrated optical isolator according to claim 6, wherein an isolation portion is formed between a certain part of the laser current injection electrode and the terminal absorbing layer arranged at the backward propagation light output waveguide output end of the optical isolator.

10. A method of manufacturing an integrated optical isolator in which a semiconductor waveguide layer is laminated on a compound semiconductor substrate, a semiconductor laser is formed on a one-side part of the semiconductor waveguide layer, and an optical isolator is formed on an other-side part, the method comprising:
removing only a region for the optical isolator after layers of the semiconductor laser are formed, and
forming the part of the optical isolator by a two-step growth which performs re-growth as another crystal growth process.

11. A method of manufacturing an integrated optical isolator in which a semiconductor waveguide layer is laminated on a compound semiconductor substrate, a semiconductor laser is formed on a one-side part of the semiconductor waveguide layer, and an optical isolator is formed on an other-side part, the method having a step of:
simultaneously forming the semiconductor waveguide layer of the optical isolator with the crystal growth process which forms layers of the semiconductor laser by using a selecting growth method.
